# EUROPEAN PATENT APPLICATION

(11) **EP 2 570 845 A1**
(43) Date of publication of application: **20.03.2013**
(21) Application number: 12778034.4
(22) Date of filing: 10.07.2012
(51) Int. Cl.: G02F 1/1343, G02F 1/1335, G02F 1/1362

(54) **ARRAY SUBSTRATE, LIQUID CRYSTAL PANEL AND DISPLAY DEVICE**

(30) Priority: 12.07.2011 CN 201110195061
(71) Applicant: Boe Technology Group Co. Ltd., Beijing 100015 (CN); Beijing BOE Display Technology Co., Ltd., Beijing 100176 (CN)
(72) Inventor: SHAO, Xibin, Beijing 100176 (CN); LIAO, Yanping, Beijing 100176 (CN); SUN, Liang, Beijing 100176 (CN); WANG, Dan, Beijing 100176 (CN)
(74) Representative: Höhfeld, Jochen
(86) International application number: PCT/CN2012/078442
(87) International publication number: WO 2013/007187

(57) **Abstract**

Embodiments of the present invention disclose an array substrate, a liquid crystal panel and a display device. In the array substrate according to an embodiment of the present invention, each part of the pixel electrode constituting the pixel unit is contained within one structural unit, and slits of different parts of the pixel electrodes, which constitute different pixel units, within the structural unit have the same inclining direction, and therefore the transmissivity of the pixel unit can be increased.

## Description

### TECHNICAL FIELD

Embodiments of the present invention relate to an array substrate, a liquid crystal panel and a display device.

### BACKGROUND

In an Advanced-Super Dimensional Switching (AD-SDS) technology, a multi-dimensional electric field is formed with both a parallel electric field produced at edges of pixel electrodes on the same plane and a vertical electric field produced between a pixel electrode layer and a common electrode layer, so that liquid crystal molecules at all orientations, which are located directly above the electrodes and between the pixel electrodes in a liquid crystal cell, can be rotated and aligned, which enhances the work efficiency of planar-oriented liquid crystals and increases light transmittance. The Advanced-Super Dimensional Switching technology can improve the picture quality of TFT-LCDs and has advantages of high transmissivity, wide viewing angles, high opening ratio, low chromatic aberration, low response time, no push Mura, etc.

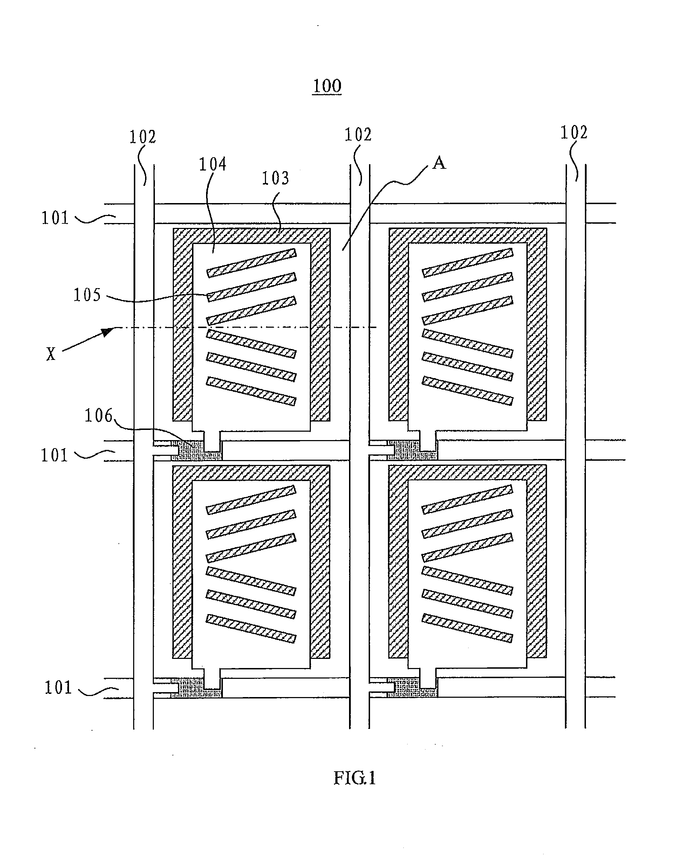

The structure of an array substrate 100 in an existing AD-SDS mode liquid crystal display is shown in FIG. 1. The array substrate 100 comprises: a plurality of gate lines 101 which are parallel to one another and formed on a transparent substrate (not shown), a plurality of common wirings (not shown), and a plurality of data lines 102 perpendicular to the gate lines 101. A portion surrounded by two adjacent gate lines 101 and two adjacent data lines 102 is referred to as a structural unit, which corresponds to a pixel unit in FIG. 1. Four pixel units with identical structure are shown in FIG. 1; here, only the constituent parts in the pixel unit on the top-left corner are denoted, and other pixel units are identical with this one in structure. Each of the pixel units includes: a transparent opposed electrode 103, which is connected to a common electrode line and covers the whole pixel unit; and a pixel electrode 104, which is disposed on the opposed electrode 103 via a transparent insulating film (not shown) therebetween and has a plurality of slits 105, which are arranged in a "<" shape as a whole. That is, the inclining direction of the slits 105 in the upper part of the pixel electrode 104 within the pixel unit and the inclining direction of the slits 105 in the lower part of the pixel electrode 104 are symmetric with each other with respect to the horizontal central axis X of the pixel electrode 104. With the alignment of the slits 105 in this manner, a color change due to viewing angle variation may be prevented from occurring in a liquid crystal display having such kind of pixel units.

The array substrate 100 as shown in FIG. 1 further includes a thin film transistor (TFT) 106 as a switching element of the pixel unit, which is disposed near the intersection between the gate line 101 and the data line 102. The source electrode of the TFT 106 is electrically connected to an extending portion of the data line 102, the drain electrode of the TFT 106 is electrically connected to the pixel electrode 104 having the plurality of slits 105 via a through hole (not shown), and the gate electrode of the TFT 106 is a part of the gate line 101.

In the course of studying the above AD-SDS mode liquid crystal display, the inventors discover that it has at least the following issues. The neighborhood of the central axis of the pixel electrode 104 is the place where the slits 105 with two different inclining directions meet with each other, and when a voltage is applied between the pixel electrode 104 and the opposed electrode 103, the liquid crystal molecules in correspondence to the place will be operated by electric fields in two directions and will substantially not be rotated due to counteraction of the two electric fields with each other. In consequence, transmissivity at the place is very low, and further, an aperture ratio of the whole liquid crystal display is decreased, which causes a poor display effect.

### SUMMARY

According to embodiments of the present invention, there are provided an array substrate, a liquid crystal panel and display device for enhancing transmissivity of a pixel unit.

In one aspect of the present invention, there is provided an array substrate, comprising: a plurality of gate lines parallel to each other and a plurality of data lines parallel to each other, two gate lines adjacent to each other and two data lines adjacent to each other defining a structural unit; and a plurality of pixel units, one of the pixel units comprising:

a first part pixel electrode having first slits and a second part pixel electrode having second slits, which are located within the structural units on two sides of a gate line, respectively, the first part pixel electrode and the second part pixel electrode being electrically connected;

wherein, within a first structural unit to which the first part pixel electrode belongs, a third part pixel electrode having third slits is disposed in a region without the first part pixel electrode; an inclining direction of the third slits and an inclining direction of the first slits are the same, and the third part pixel electrode and the first part pixel electrode are electrically separated from each other; and

within a second structural unit to which the second part pixel electrode belongs, a fourth part pixel electrode having fourth slits is disposed in a region without the second part pixel electrode; an inclining direction of the fourth slits and an inclining direction of the second slits are the same, and the fourth part pixel electrode and the second part pixel electrode are electrically separated from each other.

In another aspect of the present invention, there is provided a liquid crystal panel, comprising: a color filter substrate, the aforesaid array substrate and a liquid crystal layer interpolated between the color filter substrate and the array substrate.

In another aspect of the present invention, there is provides a display device, comprising the aforesaid liquid crystal panel.

In the array substrate, the liquid crystal panel and the display device provided in the embodiments of the present invention, each part of the pixel electrode constituting the pixel unit is contained within one structural unit, and slits of different parts of the pixel electrodes, which constitute different pixel units, within the structural unit have the same inclining direction. Therefore, an issue in a conventional technology that, slits having different inclining directions in the same structural unit form a meeting area in a central region of the structural unit so that liquid crystal molecules corresponding to the central region can not be normally rotated and transmissivity is adversely affected, can be solved. Accordingly, the array substrate according to technical solutions of the embodiments of the present invention can increase transmissivity of the pixel unit.

### BRIEF DESCRIPTION OF THE DRAWINGS

To illustrate technical solutions in embodiments of the present invention or prior art more clearly, accompanied drawings will be briefly introduced below. Obviously, the accompanied drawings described below are merely some embodiments of the present invention, and other drawings may be obtained by those skilled in the art from these accompanied drawings without creative work.

FIG. 1 is a partially schematic plan illustrating an array substrate in an existing AD-SDS mode liquid crystal display;

FIG 2 is a schematic plan illustrating a kind of pixel unit according to embodiment 1 of the present invention;

FIG. 3 is a schematic plan illustrating another kind of pixel unit according to embodiment 1 of the present invention;

FIG. 4 is a schematic plan illustrating a kind of array substrate according to embodiment 2 of the present invention;

FIG. 5 is a schematic view illustrating a liquid crystal panel according an embodiment of the present invention.

### DETAILED DESCRIPTION

Hereinafter, technical solutions in embodiments of the present invention will be clearly and fully described in combination with the accompanied drawings in the embodiments of the present invention. Apparently, the embodiments to be described herein are merely a part of embodiments of the present invention, rather than all of the embodiments. Every other embodiment, which is obtained by those ordinary skilled in the art on the basis of embodiments in the present invention without creative work, comes within the protection scope of the present invention.

Embodiment 1

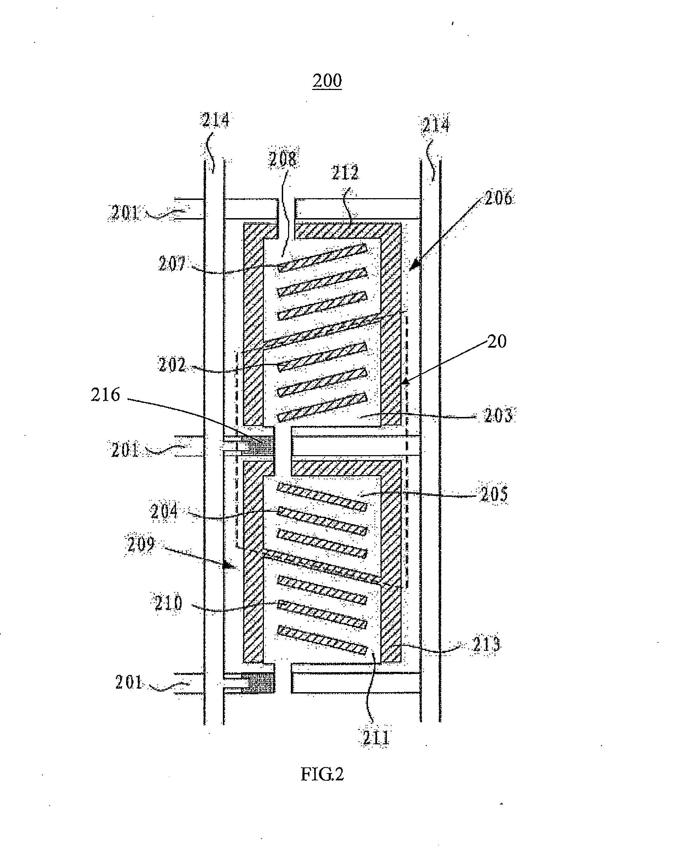

This embodiment provides an array substrate having a plurality of pixel units. As shown in FIG. 2, the array substrate 200 includes a plurality of pixel units 20 arranged in a certain array manner. These pixel units are defined by a plurality of parallel gate lines 201 and a plurality of parallel data lines 214, which are intersected with one another. A portion surrounded by two adjacent gate lines 201 and two adjacent data lines 214 form a structural unit 206, 209. On the array substrate 200, each of the pixel units 20 is the portion enclosed by the broken-line box in FIG. 2, and includes a first part pixel electrode 203 with first slits 202 and a second part pixel electrode 205 with second slits 204, which are located on two sides of a corresponding gate line 201, respectively. The first part pixel electrode 203 and the second part pixel electrode 205 are electrically connected to each other; and the inclining direction of the first slits 202 and the inclining direction of the second slits 204 are symmetric with respect to the gate line 201 located therebetween, and the first slits 202 and the second slits 204 are located within the structural unit 206 in the upper part and within the structural unit 209 in the lower part in the figure, respectively.

Within the first structural unit 206 to which the first part pixel electrode 203 belongs, a third part pixel electrode 208 with third slits 207 is disposed in (covers) a region without the first part pixel electrode 203. The third part pixel electrode 208 belongs to another adjacent pixel unit in the preceding row, and the inclining direction of the third slits 207 of the third part pixel electrode 208 and the inclining direction of the first slits 202 of the first part pixel electrode 203 are the same as each other and thus parallel to each other. The third part pixel electrode 208 and the first part pixel electrode 203 are electrically separated from each other.

Within the second structural unit 209 to which the second part pixel electrode 205 belongs, a fourth part pixel electrode 211 with fourth slits 210 is disposed in (covers) the region without the second part pixel electrode 205. The fourth part pixel electrode 211 belongs to another adjacent pixel unit in the following row, and the inclining direction of the fourth slits 210 for the fourth part pixel electrode 211 and the inclining direction of the second slits 204 for the second part pixel electrode 205 are the same as each other and thus parallel to each other. The fourth part pixel electrode 211 and the second part pixel electrode 205 are electrically separated from each other.

In an example of the embodiment, the area of the third part pixel electrode 208 and the area of the first part pixel electrode 203 are approximately equal, and the area of the fourth part pixel electrode 211 and the area of the second part pixel electrode 205 are approximately equal. In an array substrate of the AD-SDS mode liquid crystal display of the embodiment, two parts of the pixel electrode with different inclining directions of slits within the same pixel unit are made to have approximately the same area, and a better transmissivity can be achieved.

The pixel unit 20 further includes: a first opposed electrode 212 which is opposed to the first part of pixel electrode 203 via an insulating layer (not shown) therebetween; a second opposed electrode 213 which is opposed to the second part of pixel electrode 205 via an insulating layer (not shown) therebetween; and a thin film transistor (TFT) as a switching element which is located near an intersection of the gate line 201 and the data line 214. The source electrode of the TFT is electrically connected to a data line 214, the drain electrode thereof is electrically connected via a through hole to the first part pixel electrode 203 and the second part pixel electrode 205 which are electrically connected to each other, and a gate electrode thereof is a part of the corresponding gate line 201 for example.

In the embodiment, the first opposed electrode 212 and the second opposed electrode 213 are common electrodes, and for instance, are disposed on the same layer; and the first part pixel electrode 203, the second part pixel electrode 205 and the like are pixel electrodes, and for instance, are disposed on the same layer. In the pixel units according to the embodiment, the pixel electrodes can be disposed over the common electrodes, and may also be disposed under the common electrodes; the electrode disposed on the top has slits to expose the underlying electrode so as to be capable of forming a multi-dimensional electric field for driving liquid crystals when a driving voltage is applied between the electrode disposed on the top and the underlying electrode. Pixel electrodes and common electrodes stacked on top of each other can be separated from each other with a single insulating layer (e.g., a transparent resin) or with a plurality of film layers (e.g., separated with a gate insulating layer and a passivation layer); and the pixel electrodes can be electrically connected to drain electrodes of TFTs via through holes, and also can be directly overlap the drain electrodes to achieve electric connection. The foregoing cases each do not depart from the protection scope of the embodiment.

Likewise, as to the third part pixel electrode 208 for the adjacent preceding pixel unit and the fourth part pixel electrode 211 for the adjacent following pixel unit, opposed electrodes as the common electrodes are provided similarly.

In a pixel unit with the above structure, each part of the pixel electrode constituting the pixel unit is contained within a structural unit, and slits of different parts of pixel electrodes, which constitute different pixel units, within the same structural unit have the same inclining direction. Therefore, the issue, in such as a conventional technology shown in FIG. 1, that slits having different inclining directions are present in the same structural unit, and these slits form a meeting area in the central region of the structural unit so that liquid crystal molecules corresponding to the central region can not be normally rotated and transmissivity is adversely affected, can be solved. Accordingly, the structure of the pixel unit according to the embodiment can increase transmissivity of the pixel unit.

Furthermore, if in the pixel unit, the slits of the two parts of the pixel electrode, which are located within two adjacent structural units, are symmetric with each other with respect to the corresponding intermediate gate line, i.e., in an arrangement mode which is similar to that of the slits of the pixel electrode in the existing pixel unit as shown in FIG.1, a color change due to viewing angle variation also can be prevented from occurring in a liquid crystal display having the pixel unit.

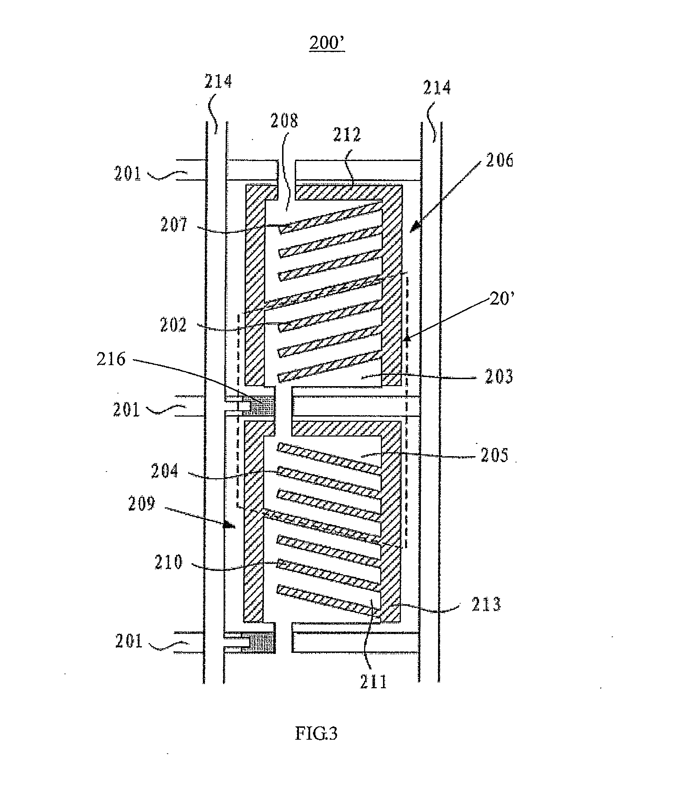

Of course the structure of slits of the first part pixel electrode 203 and the second part pixel electrode 205 is not limited to the closed structure as shown in FIG 2, and can also employ the single side opening structure as shown in FIG. 3, which accordingly can increase the opening length of the slits and enhance the utilization ratio of the space so as to further increase transmissivity of the pixel unit and save the production costs. Furthermore, the structure of slits of the first part pixel electrode 203 and the second part pixel electrode 205 can be other structure known by those skilled in the art, only if the function of driving liquid crystals can be achieved.

In a pixel unit 20' of the array substrate 200' as shown in FIG. 3, except that the structure of the slits of the pixel electrodes changes, the structures of other parts are the same as those shown in FIG. 2, and thus the same reference numerals as FIG. 2 are used.

Embodiment 2

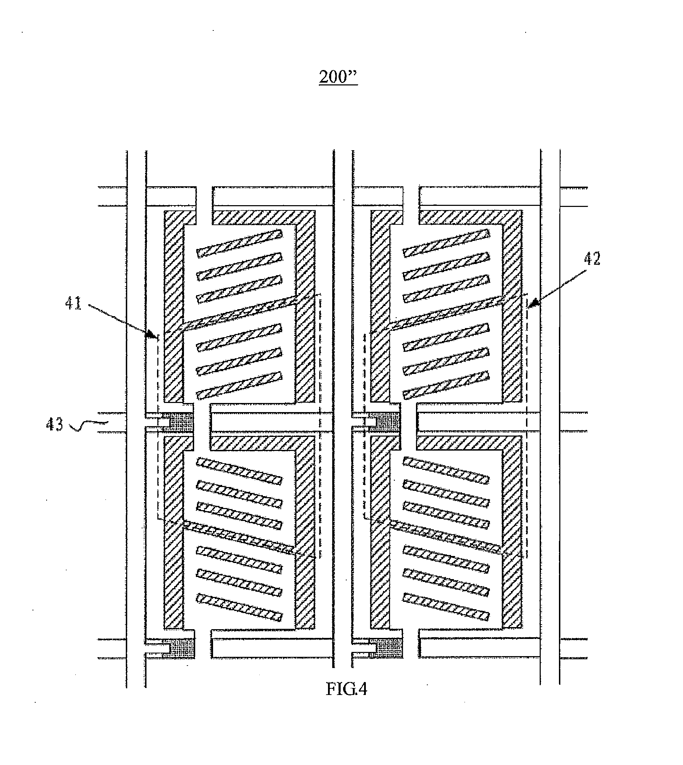

This embodiment provides an array substrate 200" having a plurality of the pixel units as provided in the embodiment 1. The pixel units crossing the same gate line on the array substrate, i.e., the pixel units under the control of the same gate line, can have the same arrangement structure for slits. As shown in FIG. 4, a first pixel unit 41 enclosed by a broken-line box and a second pixel unit 42 enclosed by another broken-line box are adjacent to each other in the extending direction of a gate line 43, and cross the same gate line 43, and the two pixel units 41 and 42 have the same arrangement structure for slits.

The two pixel units 41 and 42 may also have different arrangement structures for slits in another embodiment and, for example, are symmetric with each with respect to an intermediate data line. The arrangement structure for slits for the pixel electrode on different pixel units can be selected according to different process requirements.

As the pixel unit provided in embodiment 1 is employed in the array substrate in this embodiment, not only a color change due to viewing angle variation can be prevented from occurring in a liquid crystal display, but also transmissivity can be enhanced.

Embodiment 3

This embodiment provides a liquid crystal panel 10, which includes a color filter substrate 300 and an array substrate 200 provided in the embodiment 1 or 2. The color filter substrate 300 and the array substrate 200 are disposed opposite to each other and combined together, and a liquid crystal layer 400 is filled therebetween, so as to obtain the liquid crystal panel 10. The color filter substrate 300 may be a color filter substrate having strip-like color filters, or a color filter substrate of other type known by those skilled in the art. For example, the liquid crystal panel according to the embodiment may be configured in such a manner that the color filter substrate may have a structure in which the strip-like R, G and B are employed; and to ensure the light shading effect, a black matrix (BM) on the color filter substrate corresponds to data lines and gate lines on the array substrate.

The driving mode of signals on the array substrate of the liquid crystal panel may be a column inversion mode, or other driving mode of signals known by those skilled in the art.

As the array substrate provided from embodiment 2 is employed in the liquid crystal panel provided from the embodiment, not only a color change due to viewing angle variation can be prevented, but also transmissivity can be enhanced.

Embodiment 4

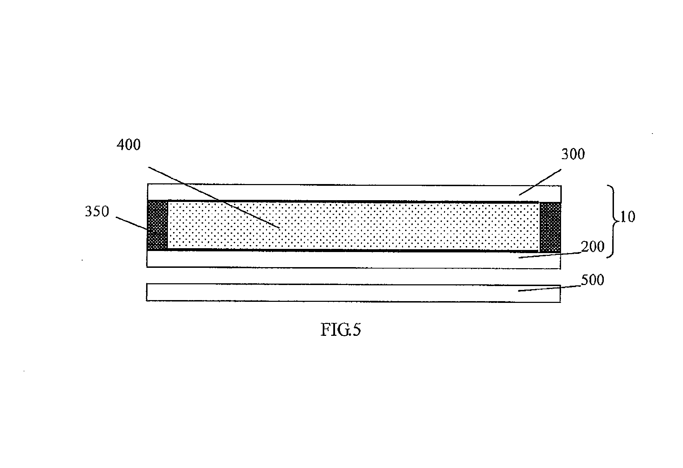

This embodiment provides a display device, which comprises the liquid crystal panel 10 provided in embodiment 3. As shown in FIG. 5, under (or behind) the liquid crystal panel 10, there may be further provided a backlight module 500 as a light source for displaying. This backlight module 500 may be a direct type or side-irradiating type, and may employ a color cathode fluorescence light (CCFL) or a light-emitting diode (LED) as a light source. The display device can be a liquid crystal display, a liquid crystal television, a tablet computer, a cell phone, a notebook computer and other device having the display function. As the liquid crystal panel according to embodiment 3 is used in the display device of the embodiment, not only a color change due to viewing angle variation can be prevented, but also transmissivity can be enhanced.

Embodiments of the present invention can be applied to an AD-SDS mode liquid crystal panel, but also can be applied to a liquid crystal panel of other type, such as an in-plain switch (IPS) type or a fringe field switch (FFS) type.

The descriptions made above are merely the specific embodiments of the present invention, but the protection scope of the present invention is not limited thereto. All such modifications or replacements falling within the technical scope disclosed by the present invention as would be obvious to those skilled in the art are intended to be included within the protection scope of the present invention. Thus, the protection scope of the present invention shall be defined by the protection scope of the following claims.

## Claims

1. An array substrate, comprising:
a plurality of gate lines parallel to each other and a plurality of data lines parallel to each other, two gate lines adjacent to each other and two data lines adjacent to each other defining a structural unit; and
a plurality of pixel units, one of the pixel units comprising:
a first part pixel electrode having first slits and a second part pixel electrode having second slits, which are located within the structural units on two sides of a gate line, respectively, the first part pixel electrode and the second part pixel electrode being electrically connected;
wherein, within a first structural unit to which the first part pixel electrode belongs, a third part pixel electrode having third slits is disposed in a region without the first part pixel electrode; an inclining direction of the third slits and an inclining direction of the first slits are the same, and the third part pixel electrode and the first part pixel electrode are electrically separated from each other; and
within a second structural unit to which the second part pixel electrode belongs, a fourth part pixel electrode having fourth slits is disposed in a region without the second part pixel electrode; an inclining direction of the fourth slits and an inclining direction of the second slits are the same, and the fourth part pixel electrode and the second part pixel electrode are electrically separated from each other.

2. The array substrate according to claim 1, wherein the first slits, the second slits, the third slits and the fourth slits have a closed structure or a single side opening structure.

3. The array substrate according to claim 1 or 2, wherein the first slits and the second slits are symmetric with each other with respect to the gate line located therebetween.

4. The array substrate according to any one of claims 1-3, wherein the third part pixel electrode belongs to a preceding pixel unit adjacent to the one of the pixel units.

5. The array substrate according to any one of claims 1-4, wherein the fourth part pixel electrode belongs to a following pixel unit adjacent to the one of the pixel units.

6. The array substrate according to any one of claims 1-5, wherein each of the pixel units further includes a common electrode opposed to the pixel electrode.

7. The array substrate according to any one of claims 1-6, wherein the pixel units crossing the same one of the gate lines have the same arrangement structure for slits.

8. The array substrate according to any one of claims 1-7, wherein two pixel units adjacent to each other in an extending direction of the gate line are symmetric with each other with respect to a data line located therebetween.

9. A liquid crystal panel, comprising:
a color filter substrate,
the above array substrate according to any one of claims 1-8; and
a liquid crystal layer interpolated between the color filter substrate and the array substrate.

10. The liquid crystal panel according to claim 9, wherein a black matrix on the color filter substrate corresponds to the data lines and the gate lines on the array substrate.

11. A display device, comprising the liquid crystal panel according to claim 8.

12. The display device according to claim 11, further comprising a backlight module which is disposed behind the liquid crystal panel for providing a light source for the liquid crystal panel.
